# EUROPEAN PATENT SPECIFICATION

(11) **EP 1 195 801 B1**
(45) Date of publication and mention of the grant of the patent: **29.01.2014**
(21) Application number: 01870205.0
(22) Date of filing: 28.09.2001
(51) Int. Cl.: H01L 21/321, H01L 21/768, H01L 21/316, H01L 23/532

(54) **Process for plasma treating an isolation layer with low permittivity**
Verfahren zur Behandlung einer Isolierschicht mit niedriger Dielektrizitätskonstante
Procédé de traitement par plasma d'une couche isolante à constante diélectrique faible

(30) Priority: 29.09.2000 US 236569
(43) Date of publication of application: 10.04.2002
(73) Proprietor: IMEC, 3001 Leuven (BE); Applied Materials, Inc., Santa Clara, California 95054-3299 (US)
(72) Inventor: Baklanov, Michael R., 3000 Leuven (BE); Vanhaelemeersch, Serge, 3001 Leuven (BE); Maex, Karen A., 3020 Herent (BE); Donaton, Ricardo, 3001 Heverlee (BE); Schaekers, Marc, 3001 Heverlee (BE); Struyf, Herbert, 2018 Antwerpen (BE)
(74) Representative: Van Malderen, Joëlle

(56) References cited:
- EP-A- 1 030 353
- WO-A-00/10199
- DELSOL R ET AL: "Transformer coupled plasma dielectric etch for 0.25 mum technologies" MICROELECTRONIC ENGINEERING, ELSEVIER PUBLISHERS BV., AMSTERDAM, NL, vol. 50, no. 1-4, 1 January 2000 (2000-01-01), pages 75-80, XP004237653 ISSN: 0167-9317
- BAKLANOV M R ET AL: "Process integration induced thermodesorption from SiO2/SiLK resin dielectric based interconnects" JOURNAL OF VACUUM SCIENCE & TECHNOLOGY B: MICROELECTRONICSPROCESSING AND PHENOMENA, AMERICAN VACUUM SOCIETY, NEW YORK, NY, US, vol. 17, no. 5, 1 September 1999 (1999-09-01), pages 2136-2146, XP012007707 ISSN: 0734-211X
- THOMPSON ET AL.: "Etch process Development for FLARE for Dual Damascene Architecture using a N2/O2 plasma" PROC. OF THE IEEE 1999 INT. INTERCONNECT TECHNOLOGY CONFERENCE, 24 May 1999 (1999-05-24), - 26 May 1999 (1999-05-26) pages 59-61, XP002524587 Piscataway, USA
- DONATON ET AL: "Critical issues in the integration of copper and low-k dielectrics", IEEE INT. INTERCONNECT TECHNOLOGY CONFERENCE, vol. 99 , pages 262-264,

## Description

### Field of the invention

The present invention is situated in the fields of micro-electronics and, more particularly, related to a process for forming semiconductor substrates.

In particular, the present invention is related to substrates having at least a dielectric layer wherein an opening is created.

### State of the art

The replacement of silicon dioxide by materials with lower dielectric constants k in metallization schemes becomes a main issue as the technologies migrate towards the 130 nm (and below) technology nodes.

As the dimensions decrease, the line to line capacitance dominates the parasitic capacitance of the interconnects and, in long parallel lines, cross talk becomes an issue due to coupling capacitance.

Even though a long list of candidates deposited, either by spin-on or vapour deposition techniques, has been investigated over the last years, it is not clear at this moment which material will be the selected one.

Among them, there is a myriad of materials with dielectric constants between 2.6 and 3.0, including diamond-like carbon films, organic polymers, hybrid organic siloxane polymers and organosilicate glasses (OSG), the later also known as carbon-doped SiO₂ or simply Si-O-C films. These films are typically low density carbon-doped oxide films having k values ranging from 2.4 to 2.9.

In the publication of Thompson et al, "Etch process development for FLARE (TM) for dual damascene architecture using a N2/O2 plasma", in PROC. of the IEEE 1999 INT. INTERCONNECT TECHNOLOGY CONF., (Picataway, USA), 24-26 May 1999, pages 59-61 is shown the integration of a low-k material in a dual damascene process and processed under O2/N2 plasma.

### Aims of the invention

The present invention aims to provide a process for forming a semiconductor substrate having at least a dielectric layer.

In particular, the present invention aims to provide a method for maintaining or conserving the dielectric constant as low as possible for modified low-k materials by performing a treatment such as a sealing on at least the exposed parts of the structure of those materials during or after the patterning of an opening, thereby preserving or improving the dielectric constant with respect to its as-deposited value.

### Summary of the invention

The invention is as defined in the appended claims.

A preferred embodiment is related to the use of a plasma O₂/N₂ within the range 1:10 to 2:1 and preferably of the order of 1:5.

Preferably, the plasma is performed with a simultaneous flow of O₂ and N₂, the O₂ flow being less than 500 sccm and preferably around 10 sccm, while the N₂ flow is less than 2500 sccm and preferably less than 50 sccm.

The set point temperature is preferably comprised between -50°C and +50°C, but is more preferably around the room temperature (20°C).

The etch pressure in the chamber is comprised between 1 mTorr and 200 mTorr, and is more preferably around 7 mTorr. (1 Torr equals 133 Pa).

The Rf top power is comprised between 100 and 3000 watt and more preferably is around 1700 watt.

The Rf bottom power is comprises between 50 and 1000 watt and more preferably is around 300 watt.

The low-k material is a silicon-oxygen material selected from the group consisting of at least Si, C and O, or at least Si, N, O, and C, or at least Si, C, O and H, or at least Si, O, C, N and H having an initial low-k value less than 3.

Advantageously, the local low-k value of the low-k material layer after the treatment is less than 2.

By "sealing step",it should be understood the structural modification that prevents the contamination by impurities or residues of the dielectric layer,and therefore seals or closes at least superficially the access of the residues to the pores of said dielectric layer.

Preferably, said sealing step is performed after the step of patterning the opening and/or stripping the resist layer.

The sealing step can also be performed during the step of creating the opening or during the step of stripping the resist layer.

### Short description of the drawings

Fig. 1a is a schematic representation of a single damascene structure wherein the chemicals diffuse into the micropores and react with the low-k material.
Fig. 1b is a schematic representation of a single damascene structure with top hard mask wherein the chemicals only modify the side walls of the opening.
Fig. 2a shows an FTIR spectrum measured from a 500 nm thick AURORA ^{™} layer.
Fig. 2b is a 3D Atomic Force Microscopy image showing the surface roughness over an area of 1 x 1 µm² of a 500 nm thick AURORA ^{™} film.
Fig. 3 represents the toluene adsorption kinetic in AURORA ^{™}.
Fig. 4 represents cross-section SEM pictures of trenches etched in AURORA ^{™} after different strips: (a) high pressure and high temperature O₂ plasma and (b) N₂/O₂ plasma (low temperature and low pressure).
Fig. 5 shows Focused Ion Beam (FIB) image of 0.25 µm Cu trenches in AURORA ^{™} made with a double hard mask (50 nm SiC / 150 nm SiO₂ (a), and resistance of 1.8 cm long meanders (0.25 µm wide) for different strips and hard masks (b). 56 chips per wafer were measured.
Fig. 6 is the interline capacitance of AURORA ^{™} trenches as a function of the line spacing for different hard masks and strips.
Fig. 7 is a cross-section FIB image of a 0.25 µm interline capacitance structure (100 nm SiC hard mask and O₂ in-situ strip).
Fig. 8 is a schematic drawing of the dielectric stack used in the etch/strip development and single damascene integration.
Fig. 9 represents cross-sectional SEM of isolated and dense 0.25 µm trenches etched on 500 nm Tri-methyl-Silane-03 low-k with 100 nm Buried low-k (Blok^{™}) hard mask from applied Materials.
Fig. 10 shows 0.25 µm isolated and dense trenches after stripping in a high pressure and high temperature oxygen plasma.
Fig. 11 shows 0.25 µm isolated and dense trenches after stripping in a O₂/CF₄ plasma at low temperature and slightly lower pressure than the process of Fig. 11.

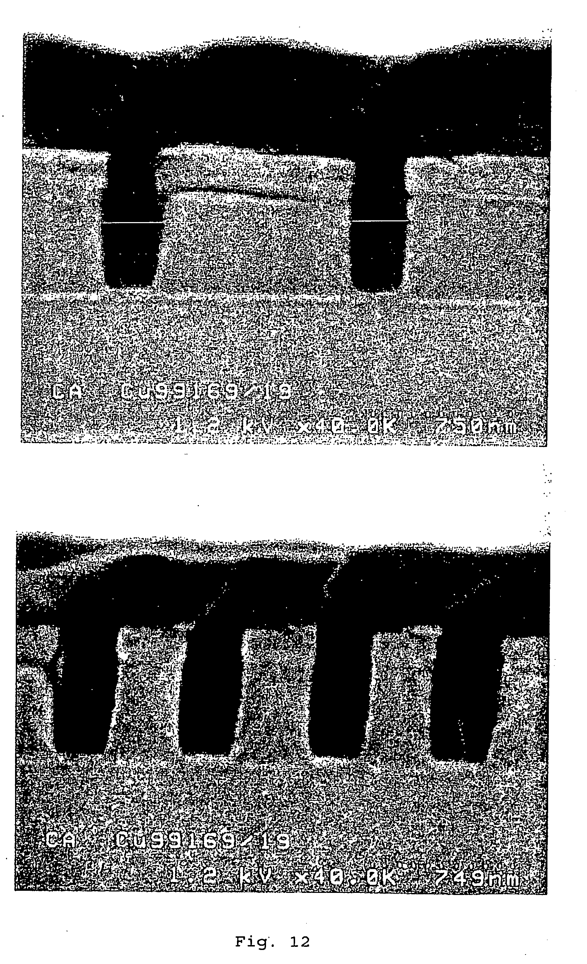

Fig. 12 shows 0.25 µm isolated and dense trenches after stripping in a H₂O/CF₄ plasma at low temperature and slightly lower pressure (similar conditions as the process shown in Fig. 11).
Fig. 13 shows 0.25 µm isolated and dense trenches after stripping in an O₂ plasma (in-situ) at low temperature and low pressure.
Fig. 14 shows 0.25 µm isolated and dense trenches after stripping in a N₂/O₂ plasma.
Fig. 15 shows the interline capacitance measured at 100 kHz and simulated for different line spacing after single damascene process, using the water vapour strip process. The solid lines represent simulation results with different dielectric constant values. Below, FIB image of the interline capacitance structure (nominal 0.25/0.25 µm line/space). Due to the poor contrast between the Pt used for (FIB preparation) and the SiC, the top hard mask cannot be clearly seen in this image.
Fig. 16 shows the interline capacitance measured at 100 kHz and simulated for different line spacing after single damascene process, using the O₂ in-situ strip process. The solid lines represent simulation results with different dielectric constant values. Below, FIB image of the interline capacitance structure (nominal 0.25/0.25 µm line/space). Due to the poor contrast between the Pt (FIB preparation) and SiC, the top hard mask cannot be clearly seen in this image.
Fig. 17 shows the interline capacitance measured at 100 kHz and simulated for different line spacing after single damascene process, using the N₂/O₂ in-situ strip process. The solid lines represent simulation results with different dielectric constant values. Below, FIB image of the interline capacitance structure (nominal 0.25/0.25 µm line/space). Due to the poor contrast between the Pt (FIB preparation) and SiC, the top hard mask cannot be clearly seen in this image.
Figs. 18 a-d show a process sequence according to a preferred embodiment of the present invention.

### Detailed description of the invention

All drawings are intended to illustrate some aspects and embodiments of the present invention. Devices and fabrication steps are depicted in a simplified way for reason of clarity. Not all alternatives and options are shown and therefore the invention is not limited to the content of the given drawings.

Scaling the dielectric constant is one of the main driving forces for research and development of new back-end-of-line dielectrics. The scalability of the k value has become a significant parameter in the selection process of appropriate low-k dielectrics. Investigation of new dielectrics in view of chemical composition, physical structure and related properties of the as-deposited film is only one aspect in research towards successful implementation of low-k dielectrics.

Detailed understanding of the interaction between the deposited film and subsequent process steps, such as plasma and/or chemical treatments on the material within its fine patterned features, gives valuable information to control the low-k material.

It has become clear that the impact of further process steps on the final material characteristics is related to the as-deposited or modified material properties and that these interactions can be used to protect the low-k material from degradation. Probably even more important are process interactions which can be used to improve or at least preserve the k value of the material locally.

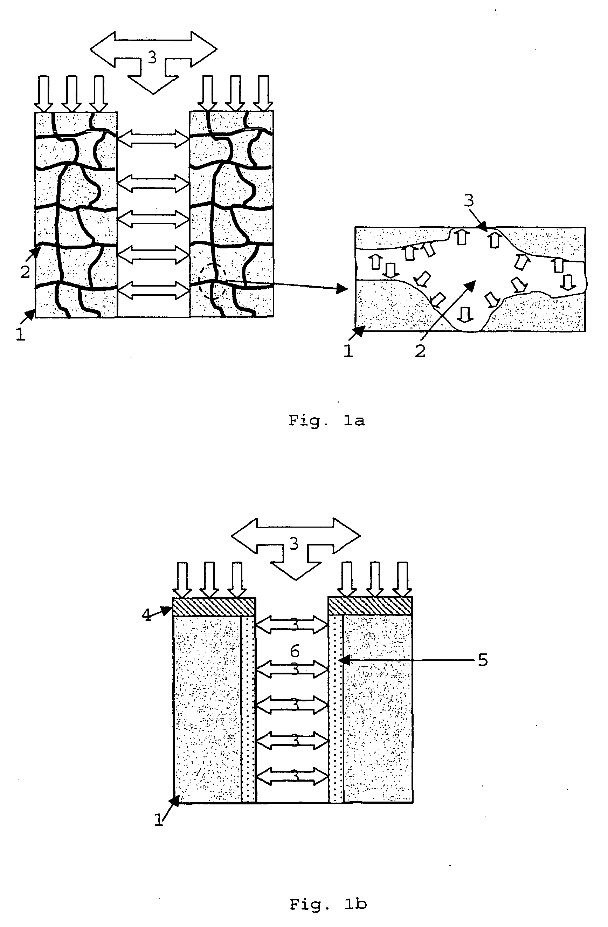

A rather direct and practical way to reduce the k-value of the film is the introduction of pores in the dielectric as illustrated in Fig. 1a. Etch and strip chemicals 3 penetrate into the low-k material 1. The degree of penetration depends on pore size and properties of the chemical species used.

Fig. 1b illustrates the case in which the low-k material 1 is covered with a hard mask 4. During subsequent processing, e.g. during patterning, stripping or cleaning steps, preferably only the side walls of the opening 6 are exposed to the chemicals 3. Such patterning or post patterning treatments change the material features at the side walls 5. However, the relative contribution of the side wall material is dominant for narrow spacing and this is exactly the place where lowering of the k-value is most important.

In the Application EP-A-1037275 a method is disclosed for forming a porous silicon oxide film by exposing a polymer film comprising Si and C to an oxidising plasma. The oxidising plasma changes the porosity of the as-deposited uniform layer and hence the dielectric constant of this layer.

The lateral and/or vertical diffusion of the chemical species is very fast in the micropores 2. The reaction with the low-k material itself however is slow compared to the diffusion of said chemicals, but this reaction takes place at each pore wall exposed to the chemicals.

The very small reactions at the pore wall can have a large effect on the overall k-value, while the thickness of the low-k material remains substantially unchanged as illustrated in Fig. 1b the low-k dielectric is only locally exposed to the chemicals. Whereas in the prior art document EP-A-1037275 the top surface of the low-k dielectric 1 is being subject to chemicals, e.g. a plasma, in fig. 1b, only the side walls 5 of the opening 6 are in direct contact with the chemicals 3 by the top hard mask 3 which is resistant to the chemicals applied. This top hard mask layer 4 is known in damascence technology and comprises silicon or nitrides, carbides and oxides, e.g. SiO₂, Si₃N₄, SiC, SiOC.

The low-k material can be a silicon-oxygen layer. For the purpose of this invention silicon-oxygen should be understood as a material being composed of at least Si, C and O, e.g. silicon oxycarbide (SiOC), or at least Si, N, O, and C, e.g. nitrited silicon oxycarbide (SiNOC), or at least Si, C, O and H, e.g. hydrogenated SiOC, or at least Si, O,C, N and H , e.g. hydrogenated SiNOC.

The low-k material can be a carbide-silicon layer. At least for the purpose of this disclosure a carbide-silicon layer is an electrically insulating layer being composed of at least Si and C, e.g. SiC, or of at least Si, C and O, e.g.. a silicon oxycarbide (SiOC), or at least Si, C and H as e.g. amorphous hydrogenated silicon carbide SiC:H.

In a first preferred embodiment, the preservation of the dielectric constant of a DMS-based low-k dielectric is disclosed.

### Film deposition

The AURORA ^{™} films is deposited in a single-wafer, parallel plate plasma-enhanced- CVD system based on an Eagle-10 system from ASM International, a Netherlands-based company. AURORA ^{™} is a trade mark used by ASM to identify the low-k product formed on the Eagle-10 system using dimethyldimethoxysilane (DMS) is used as precursor and He as additive gas. Temperature during deposition was 400 °C. The deposited films have a refractive index of 1.41, as measured by spectroscopic ellipsometry.

### Film structure

Fourier Transform Infrared Spectroscopy (FTIR) is used to characterise the AURORA ^{™} film structure. Fig. 1 shows an infra-red spectrum obtained from a 500 nm thick AURORA ^{™} film. The strong absorption peak observed at 1040 cm⁻¹ results from the presence of Si-O bonds (stretch) in the film. Also observed in the spectrum are peaks corresponding to CH₃ (2970 cm⁻¹), CH and CH₂ asymmetric bonds at 2910 cm⁻¹, a small peak at 2170 cm⁻¹ that corresponds to Si-H bonds, the antisymmetric and symmetric deformation of C-H in a Si-(CH₂)ₙ-Si at 1412 and 1360 cm⁻¹ respectively [5], and a strong peak at 1280 cm⁻¹ corresponding to CH₃-Si bonds. A peak around 800 cm⁻¹ is also observed, and it can be assigned to Si-C, Si-CH₂ and Si-CH₃ bonds. FTIR spectra measured at centre and edge of the wafer, for both 250 and 500 nm thick AURORA ^{™} films showed the exact same features, indicating a good uniformity in the film structure. No indication of moisture uptake is observed from the FTIR spectrum, even after a month of storage in clean room environment.

### Film composition and surface roughness

Rutherford Backscattering Spectrometry (RBS) and Elastic Recoil Detection (ERD) are used to study the composition of AURORA ^{™} films. ERD is used for hydrogen detection. Energies of 3.045 MeV and 4.26 MeV are used for resonance measurements of oxygen and carbon, respectively. A composition of 25% Si, 50% O, 20% C and 5% H is found.

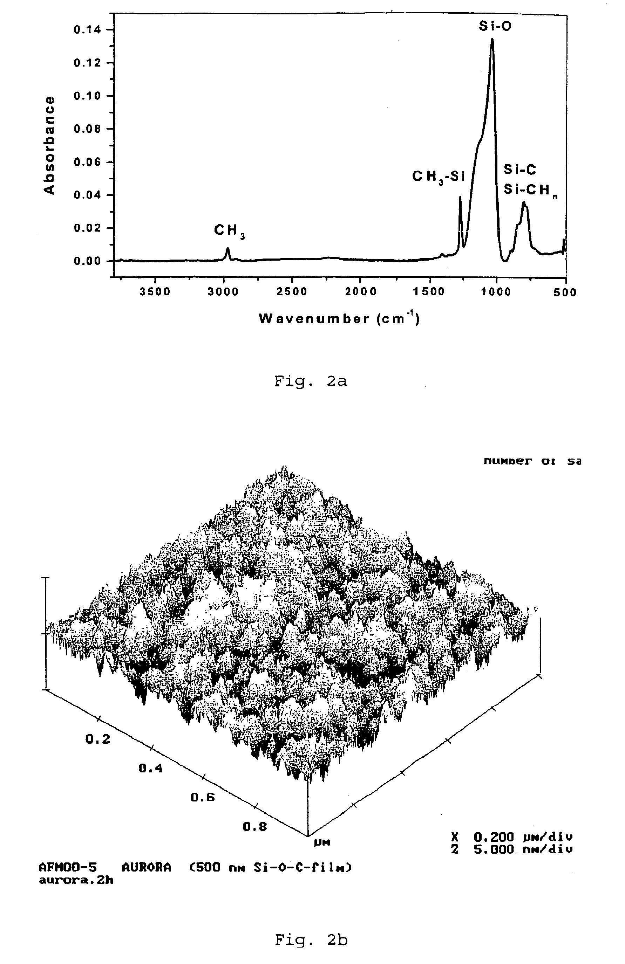

The surface roughness of a 500 nm thick AURORA ^{™} film was analysed by atomic force microscopy (AFM). Roughness was measured over different spots on the sample and the scans were done over different areas (1 x 1, 2 x 2 and 5 x 5 µm²). Fig. 2 shows a 3D image of the film surface. An average surface roughness below 0.5 nm is found, and this value is independent of the area measured.

### Porosity

Ellipsometric porosimetry (EP), which is a new version of adsorption porosimetry, is a powerful technique to characterize the porosity of microporous materials such as AURORA ^{™}.

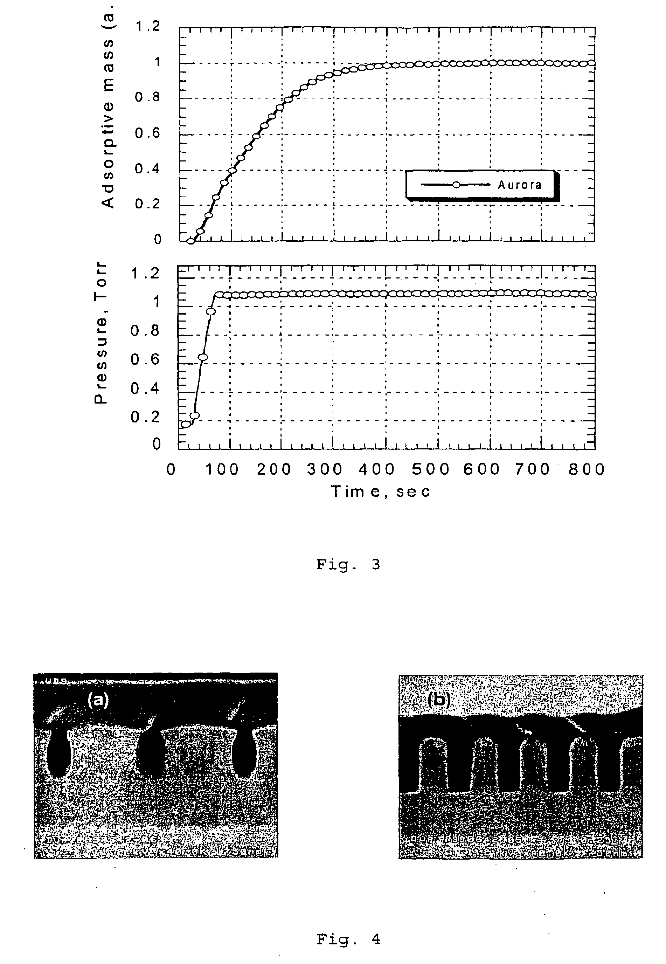

In this method, the mass of an adsorptive condensed / adsorbed in the pores is determined by changes in the optical characteristics of the porous film during vapour adsorption and desorption. Fig. 3 shows the kinetic evolution of the adsorptive mass into AURORA ^{™}. Toluene, which has a molecule kinetic diameter around 0.6 nm, is used as adsorbate vapour. In the same figure the increase of the pressure in the chamber, due to the introduction of toluene vapour, is shown as a function of time. If the film had a pore diameter larger than the kinetic diameter of the toluene molecule, the adsorbate amount in the film would increase in the same rate as the vapour pressure in the chamber.

It can be seen that adsorption of toluene into the AURORA ^{™} film occurred in a much slower way than the change of the vapour pressure. This suggests that the pore diameter of AURORA ^{™} is comparable to the kinetic diameter of the toluene molecule, i.e. AURORA ^{™} ≈ 0.6 nm. This reduced pore size of AURORA ^{™} can be advantageous during integration of this material in damascene structures.

### Electrical properties - blanket films

Dielectric constant, leakage current and breakdown field were measured using a metal / insulator / metal (MIM) structure, with the top electrode patterned by lithography and dry etch for accurate area determination. Capacitance vs. frequency (C-F) measurements were performed. The values reported here were taken at a frequency of 100 kHz.

Capacitors of different sizes were measured. At least 5 different sites on the wafers were probed. The thickness of the AURORA ^{™} layers used in the calculation of the dielectric constant was measured by spectroscopic ellipsometry. The capacitors measured were located as close as possible to the thickness measurement sites.

A dielectric constant of 2.9 was found for the AURORA ^{™} films deposited at IMEC. The dielectric constant was the same for all the various film thicknesses, and did not change during a period of a month (maximum time interval measured). Annealing the samples at 400°C for 20 minutes did not result in any change of the dielectric constant. A standard deviation of the measurements of around 1% is found, indicating that the dielectric constant does not vary significantly over the wafer.

Leakage current was measured at a field of 1 MV/cm. The measurements were carried out in a nitrogen environment. The leakage current values are below 10⁻¹¹ A/cm² and are independent of processing conditions and thickness. The AURORA ^{™} films did not show breakdown up to fields of 2 MV/cm. The measurements were limited to this field by the equipment set-up and film thickness.

### Single damascene integration

As any Si-O-C type material, AURORA ^{™} is expected to be sensitive to resist strip processes during patterning of damascene structures, since it involves the use of plasma with oxygen chemistries.

Single damascene structures using 500 nm AURORA ^{™} with a 100 nm α-SiC:H (referred as SiC from this point on) etch stop layer were fabricated. Two different hard masks were used: 100 nm SiC or a double layer 50 nm SiC / 150 nm SiO₂. Etching of hard mask and AURORA ^{™} was carried out in a LAM 4520XL, a dual frequency reactive ion etch (RIE) system designed for advanced oxide etch applications and offered by LAM, a united States based Company. The 100 nm SiC hard mask was etched using an Ar/N₂/CF₄/O₂ chemistry, which resulted in good CD-control and etch uniformity. Due to differences in etch rates of oxide and SiC, the same etch time used for etching 100 nm SiC could be used for opening of the double hard mask, with similar characteristics for CD-control and uniformity.

Etching of the trenches was done using a Ar/CF₄/CHF₃/O₂ chemistry, resulting in trenches with straight profiles and no faceting of the hard mask was observed. Various stripping processes were evaluated in order to remove the remaining photo resist and polymers formed during the trench etch. A downstream O₂ plasma (high temperature, high pressure) and a O₂/CF₄ plasma (lower pressure and temperature) resulted in undercut and bowing, as can be seen in fig. 4a.

The severe conditions during the strip caused a modification of the film leading to shrinkage of the layer, as can be observed at the side walls of the trenches. On the other hand, a LAM 4520XL in-situ O₂ strip performed at low pressure and low temperature resulted in reasonable profiles, with practically no undercut or bowing of the trenches.

However, from patterning point of view, the best strip process was the one carried out in a LAM TCP9100 chamber, based on LAM's Transformer Coupled Plasma ^{™} technology, at low temperature and low pressure using N₂/O₂ chemistry. Fig. 4b shows a cross-section SEM image of AURORA ^{™} trenches after stripping in N₂/O₂. No bowing or undercut is present, and some rounding of the hard mask is observed due to this Reactive Ion Etch (RIE)-type strip.

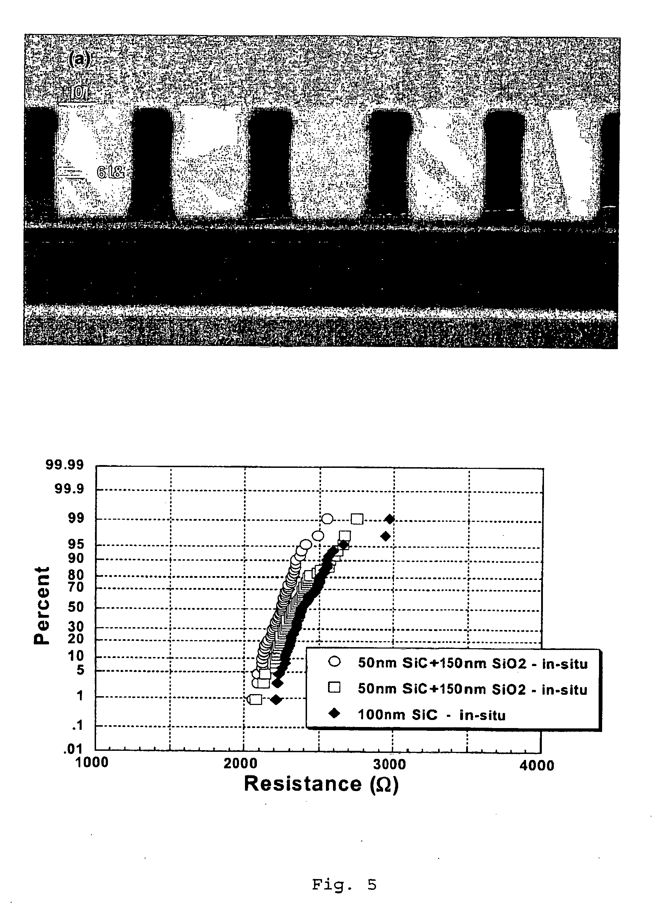

Integration of AURORA ^{™} in single damascene structures was successfully achieved. Fig. 5 shows a cross-section image of 0.25 µm Cu trenches of a meander/fork structure made in AURORA ^{™} with the 50 nm SiC / 150 nm SiO₂ double hard mask. The resistance of 1.8 cm long meanders is also shown in the figure.

The metallization scheme consisted of PVD TaN followed by PVD Cu seed layer and subsequent Cu electroplating fill in an ECD chamber from Semitool.

The wafer with 100 nm SiC hard mask stripped with the O₂ in-situ process shows slightly higher values than the ones with the double hard mask and same strip. The small difference comes from the fact that the total trench depth is smaller (due to the thinner hard mask) and less hard mask is removed during the CMP process when 100 nm SiC is used.

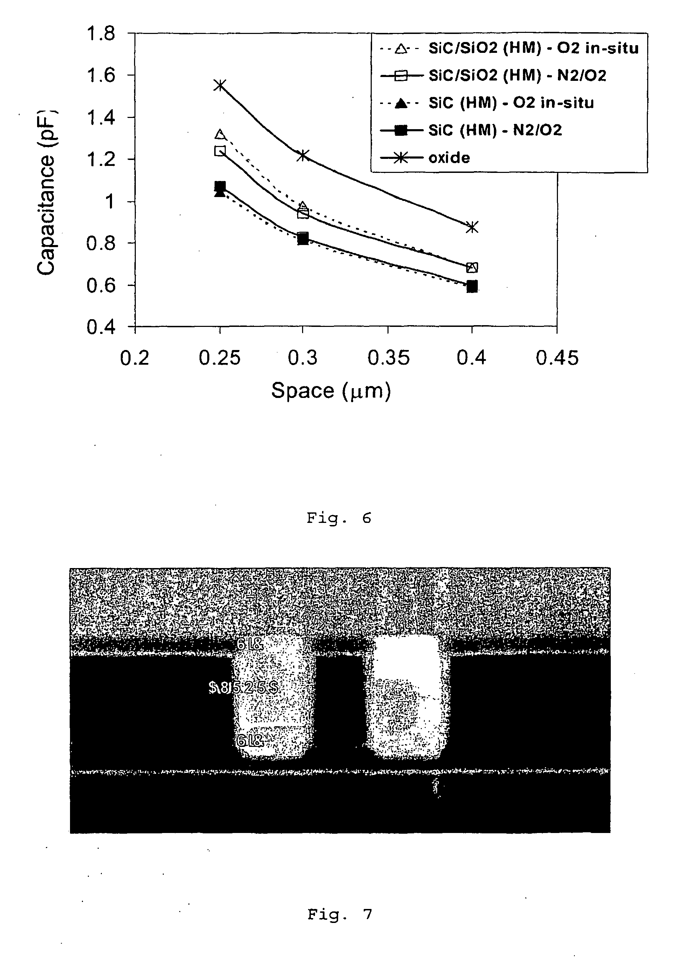

Interline capacitance measurements are very useful to investigate the effect of processing steps on the dielectric constant of the low-k material being integrated. Fig. 6 shows interline capacitance as a function of various line spacings for wafers with different hard masks and different strip processes.

### Interline capacitance

Interline capacitance of single damascene oxide structures is plotted for comparison. The capacitance of the structures prepared with the double hard mask (SiC/SiO₂) is higher than the ones prepared with a single SiC hard mask due to the higher thickness of the trenches (- 60 nm thicker). No significant difference is observed between the two different strip splits: O₂ in-situ and N₂/O₂.

In order to evaluate the effect of these two strip processes on the dielectric constant of AURORA ^{™} simulations using TMA Raphael software were done. The actual profile of the measured structures, determined from FIB cross-section images (Fig. 7), was used in the simulations.

The line spacing was not dependent on the strip used, according to these images, which is in agreement with the capacitance measurements. From the simulations and electrical measurements, a dielectric constant of 2.7 was found for AURORA ^{™}, down to line spacing of 0.25 µm. This value is lower than the value obtained for blanket AURORA ^{™} wafers, being 2.9, extracted from MIM capacitors.

The lower k-value found can be due to the modification of the material at the trench side wall, resulting in a less dense film with lower dielectric constant. One possible explanation for the lowering of the dielectric constant between lines upon single damascene integration is the formation of a modified material with lower density (more porous), due to the removal of carbon from the film during the strip process.

Similar mechanism was observed during oxidation of a-SiC:H films. This idea is supported by results obtained from experiments performed on blanket wafers exposed to different plasma treatments, and taking into account the differences between etching blanket films and trenches.

In the present invention the preservation of a locally modified TMS-O3 low-k film is discussed.

### Film deposition

Deposition of the TMS-O3 based low-k dielectric was done in a sub-atmospheric chemical vapour deposition (SACVD) CxZ chamber of Applied Materials, a United States-based company.

### Film structure

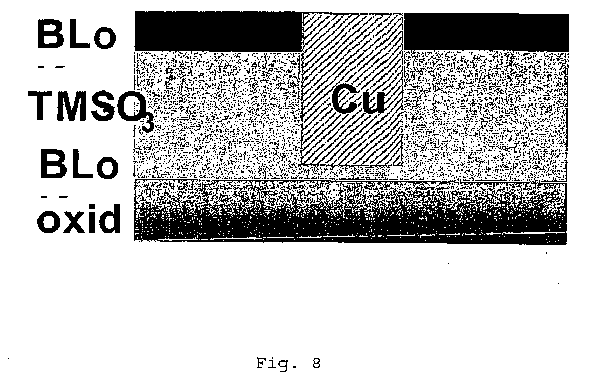

The film structure is investigated by FTIR and a typical spectrum of the film is given in Fig. 8. The main features in this spectrum are the strong absorption peaks due the presence of the Si-O bonds and the presence of C-H and Si-CH₃ bonds. The film has a stress value of 6 10⁸ dynes/cm² (60MPa) and this value is the same after thermal cycling up to 500 °C. The film is stable to temperatures up to 550 °C, as found by thermal desorption spectroscopy (TDS) analysis.

### Single Damascene Integration

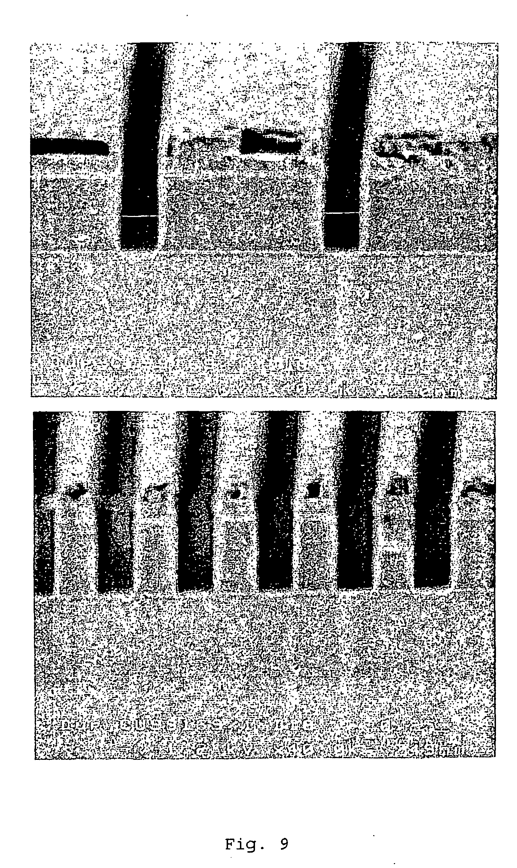

The single-damascene stack consists of (from Si substrate) 50 nm SiN / 500 nm SiO2 / 50 nm BloK / 500 nm TMS-O3 / 100 nm BloK as shown in Fig. 9. BloK stands for Buried Low-k material and comprises SiC. The etchings have been performed in a LAM 4520 XL tool. Results are presented for tests on patterned wafers. Also, a limited number of strip experiments has been conducted. It is important to mention that the lithography process was target to 0.25 µm dimensions.

First the hardmask (HM)-opening of the 100 nm SiC layer is performed using a slightly modified recipe that is standardly used in oxide damascene etching. This Ar/N₂/CF₄/O₂ recipe yields very straight (remaining) resist and SiC profiles, and sufficient resist selectivity, as about 250 nm of resist is left in between dense trenches for the standard process. The disadvantage however, lies in the side wall roughness which is generated by this process, and which is only visible in top-down inspection.

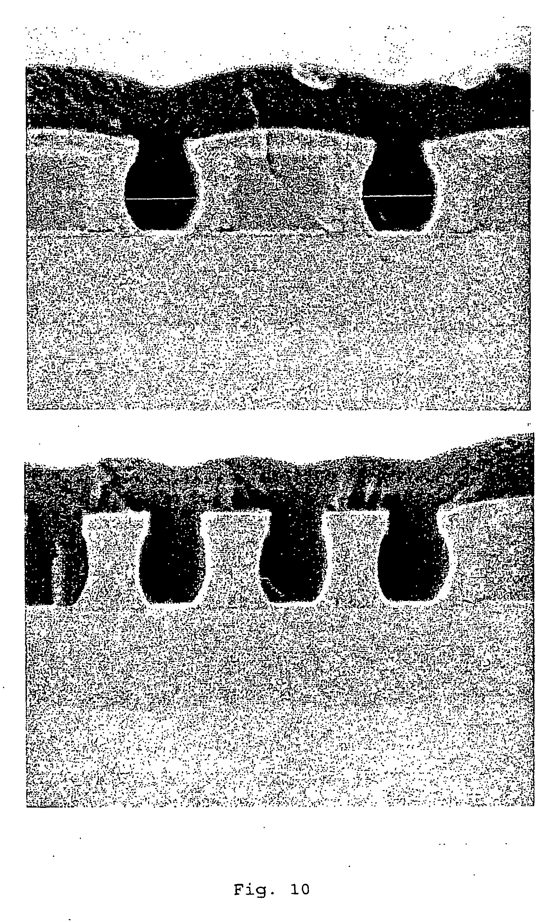

After the opening of the hardmask, an opening is etched in the low-k layer using Ar/CF₄/CHF₃/O₂. This combination of hard mask and low-k etch chemistries yielded good results: there was still resist left (80 nm in between the dense 0.25 µm trenches), which was only slightly sloped. A good uniformity was observed for dense and isolated features. The bottom sizes are on target, while there is little CD gain to be seen for the trench top sizes. From the etch development it is observed that reducing the O₂ flow in the low-k etch step slightly improves the dense/isolated uniformity but makes the profiles more sloped. More resist remains on the wafer but on the other hand the low-k etch-rate decreases considerably. Also, the top and bottom trench widths become slightly smaller (20 to 30 nm). Overall, a good profile is obtained after etch for dense and isolated trenches. Fig. 10 shows cross-section SEM images of isolated and dense 0.25 µm trenches after etching.

It is known that resist removal process is a critical step in the patterning of Si-O-C type materials, since these films are very sensitive to oxygen plasma processes. Five resist stripping recipes were selected and tested.

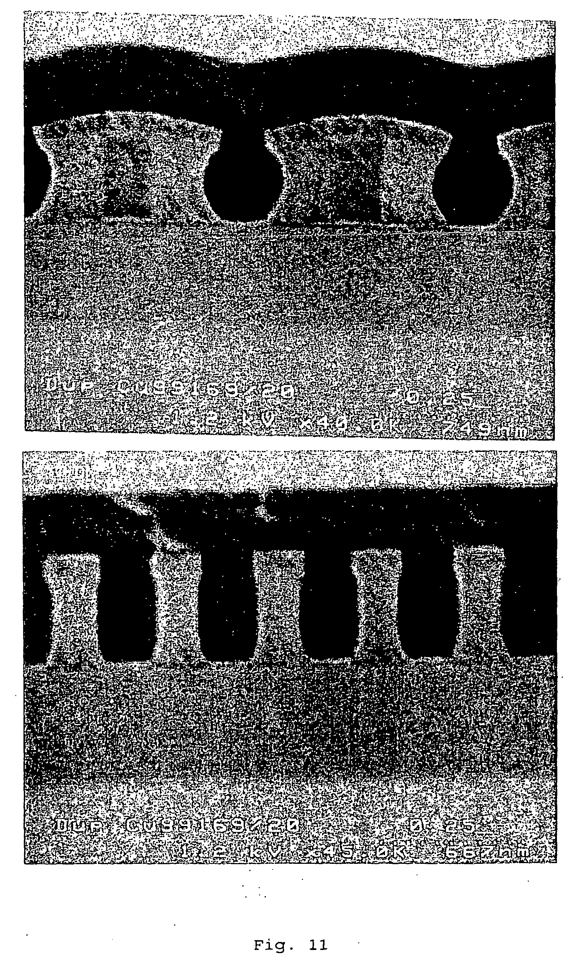

The results for the wafer that was subjected to a "standard" O₂ ashing, being carried out in a standard Inductively Coupled Plasma (ICP) chamber of an ASPEN system offered by Mattson a United States-based company, at high pressure and high temperature, are presented in Fig. 11. There is severe shrinkage and bowing of the low-k film to be observed. The bowing is especially apparent for the (semi-) isolated trenches. Also, upon closer inspection of the SEM pictures it becomes clear that the structure of low-k material has changed for about 250 nm, measuring sideways from the side walls into the bulk of the low-k material.

Another ashing process performed in a Mattson ICP Selectable Mode chamber using a O₂/CF₄ chemistry at lower temperature and slightly lower pressure than the previous process resulted in similar features. These results confirm that the TMS-O3 low-k material is very sensitive to the oxygen plasma, which resulted in a clear modification of the film close to the side walls of the trenches.

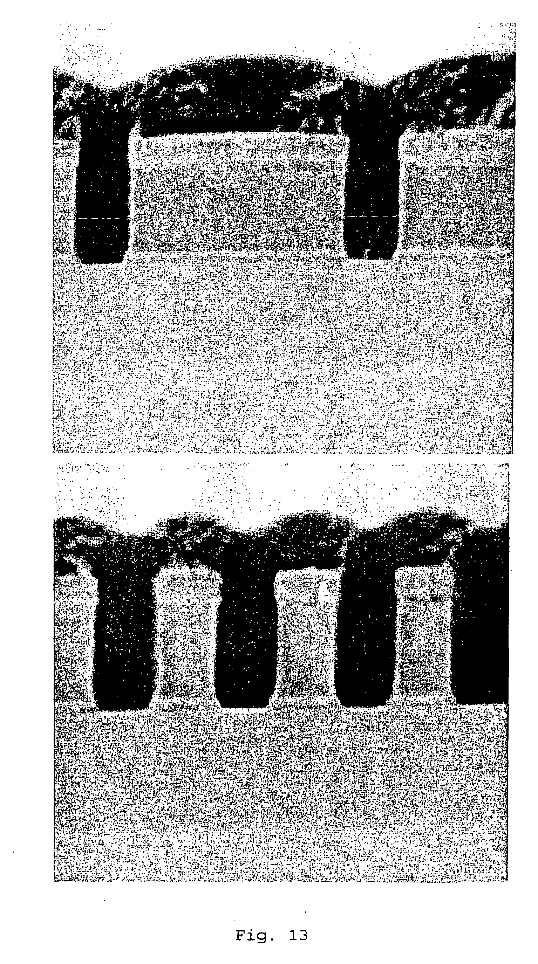

The strip results look much better for the H₂O-vapour strip, with some CF₄ addition, also carried out in the Mattson ICP Selectable Mode chamber at the same temperature and pressure conditions as the second strip process (i.e. lower temperature and slightly lower pressure). Limited undercut/bowing is visible, but the chance that these trenches will be filled with Cu is considerably larger than for the previous strips sequences. Fig. 13 shows cross section SEM images of isolated and dense trenches after stripping with this process.

Two other stripping processes done at much lower temperature and pressure conditions than the previous ones were tried and the results are described below.

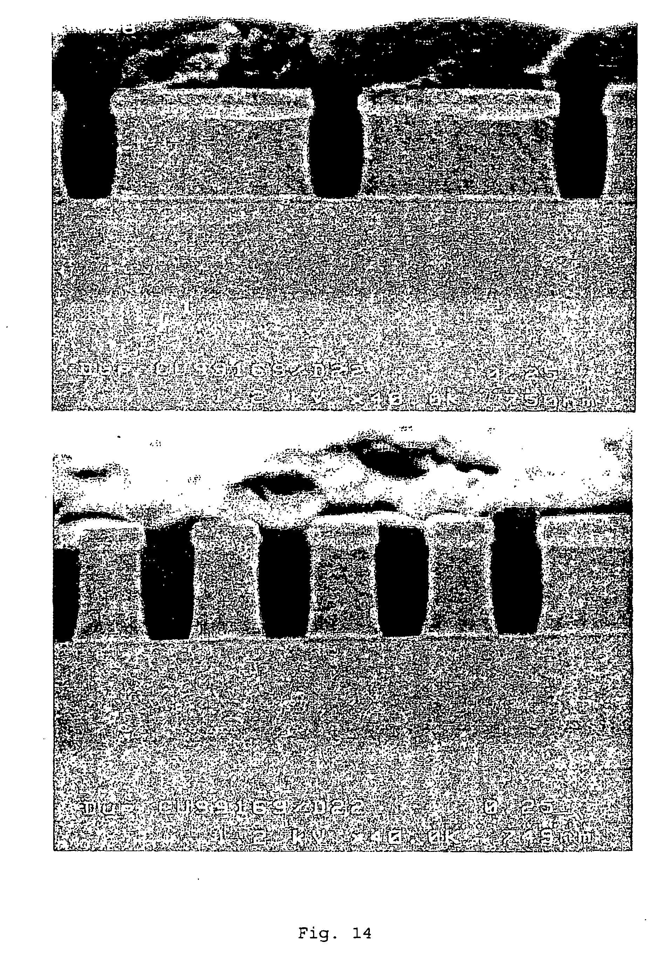

From a throughput point-of-view, an in-situ strip in the Lam 4520-XL could prove to be extremely beneficial. Fig. 14 shows the trenches profiles of the wafer stripped in an O₂ plasma (in-situ) at low pressure and low temperature. Reduced undercut is observed. Generally, the trenches look acceptable except for the fact that the oxide underneath the SiC stopping-layer appears to have been etched for all features. As the etch process applied to this wafer was exactly the same as for the other stripped wafers, this can only be attributed to the stripping method. It is believed that the fluorine which is present in the chamber and on the wafer after the etch could be responsible for this unwanted bottom SiC etch during the resist strip.

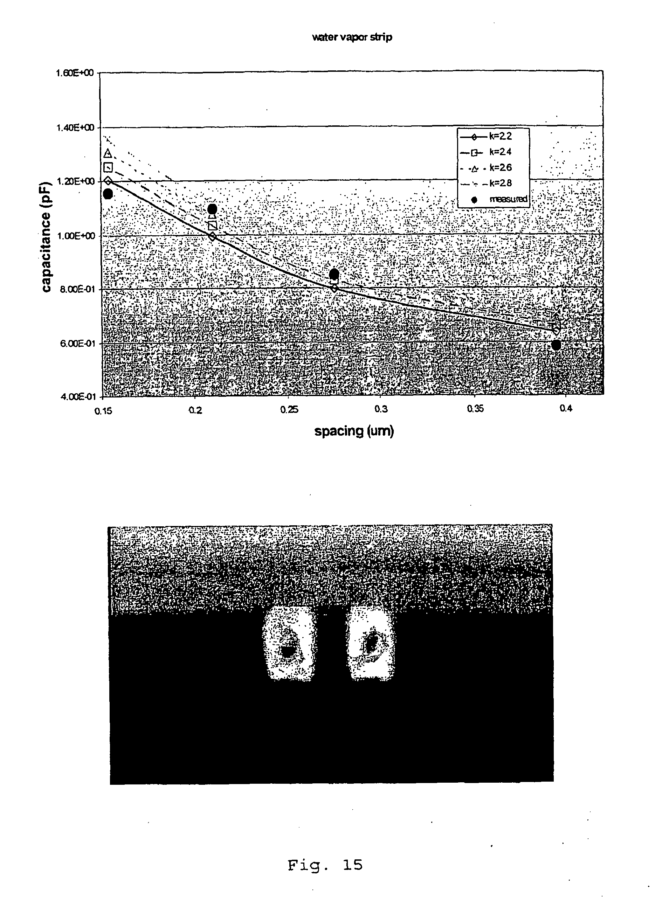

Finally, the invention is based on a N₂/O₂ strip in the Lam TCP9100 chamber (at low pressure and low temperature). As can be concluded from the images in Fig. 15, slight bowing and undercut are observed as a result of this process. The fact that this is an RIE-type strip causing the top HM to be rounded. However, no CD gain is observed and it is believed that this rounding will be beneficial towards Cu-fill. CD stands for critical dimension and is used to identify the feature dimensions under investigation. In case of an opening, this CD is the width of the opening and the variation of this width along the depth of the opening.

### Interline capacitance

From the results obtained in the etch/strip development, one etch process and three different stripping processes were chosen to pattern the wafers for integration into single damascene structures. The etching process consisted of a first step using Ar/N₂/CF₄/O₂ for hard mask opening followed by Ar/CF₄/CHF₃/O₂ for etching of the low-k material. Low temperature and low pressure N₂/O₂ and in-situ O₂ plasma and the "standard" H₂O-vapour strip processes were used as splits in the wafer processing.

The metallization scheme consisted of deposition of Physical Vapour Deposition (PVD) TaN barrier followed by PVD Cu seed layer deposition, done in the Applied MATerials Electra-tool. The trenches were then electroplated filled in a Semitool Electro Chemical Deposition (ECD) chamber. Chemical Mechanical Polishing was performed in an IPEC 676 tool. The conditions of these processes were kept constant.

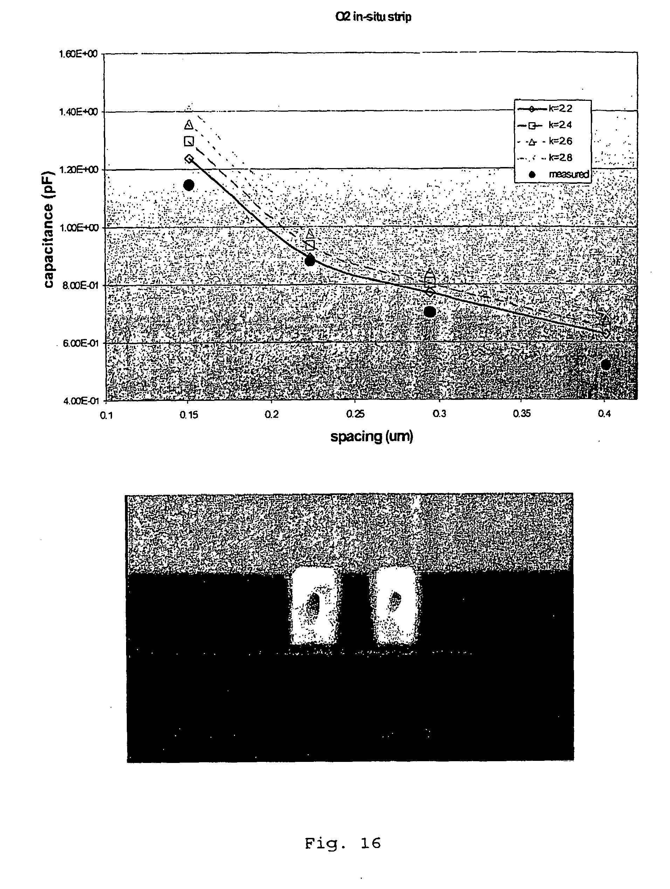

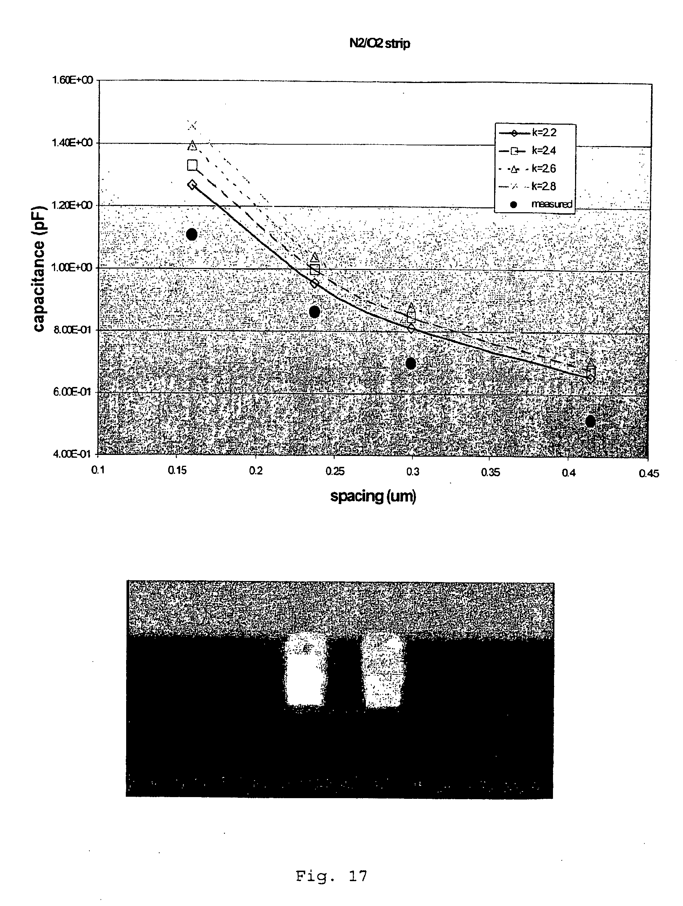

Interline capacitance structures consisting of long parallel lines with spacing varying from 0.4 down to 0.2 micron were measured. 16 chips per wafer were manually measured (a column from north to south and a row from east to west). After measurements, the wafers were sent for cross-section FIB and later SEM analysis, in order to determine the real profile of the structures (trench and spacing dimensions, hard mask and trench thicknesses) electrically measured. The correct dimensions were used in the simulations performed for estimation of the dielectric constant of the TMS-O3 material after full integration into single damascene structures. The TMA Raphael software package was used in the simulations. Figs. 16 and 17 show the interline capacitance as a function of actual spacing between the lines, as extracted from the FIB and SEM cross-section images.

In the graphs, the measured value (solid circles) is plotted together with the simulation results for different k values of the low-k material (from 2.2 up to 2.8). The dielectric constant values of the other materials used in the simulations were 4.3 for SiO₂ and SiC and 8 for SiN.

From the cross-section images, it is clear that the water vapour strip resulted in a much narrower spacing than the other strip splits. As previously shown in the etch/strip section, this strip results in more trench undercut and bowing than the others. This can explain the significant decrease in the line spacing compared to the nominal value. This bowing and undercut have an impact on the filling process, since both barrier and seed layers are deposited by PVD. The other two strip splits resulted in comparable line spacings, with the N₂/O₂ strip showing slightly better performance with respect to bowing/undercut. This is corroborated by the quality of the filling process, which is not significantly affected by that in the case of the N₂/O₂ strip process.

Looking at the capacitance vs. line spacing plots it is striking the fact that the measured values are close to or below the simulated values for a k = 2.2. A dielectric constant value of 2.2 is very low for a Si-O-C type material. An error of approximately 10 % has to be taken into account due to the uncertainties of the different parameters used in the simulation. Still, the value measured is considered considerably low. This fact is very pronounced for two of the three strip splits: N₂/O₂ and O₂ in-situ, with the first showing a lower k value. The water vapour strip resulted in significantly higher k value, when compared to the other stripping processes. One possible explanation for this low dielectric constant value found after single damascene integration can be the fact that the low-k film is modified during the ashing process. The film could be converted into a more porous film (or lower density) due to the removal of C from the film in the presence of oxygen during the stripping process.

It is important to mention that only the side wall of the trenches were exposed to the plasma during the ashing process, since a hard mask was always present on the surface, therefore avoiding direct exposure of the low-k film to the plasma.

It is also important to mention that the values shown in the graphs correspond to one chip on the wafer, the chip that was used for cross section FIB and SEM.

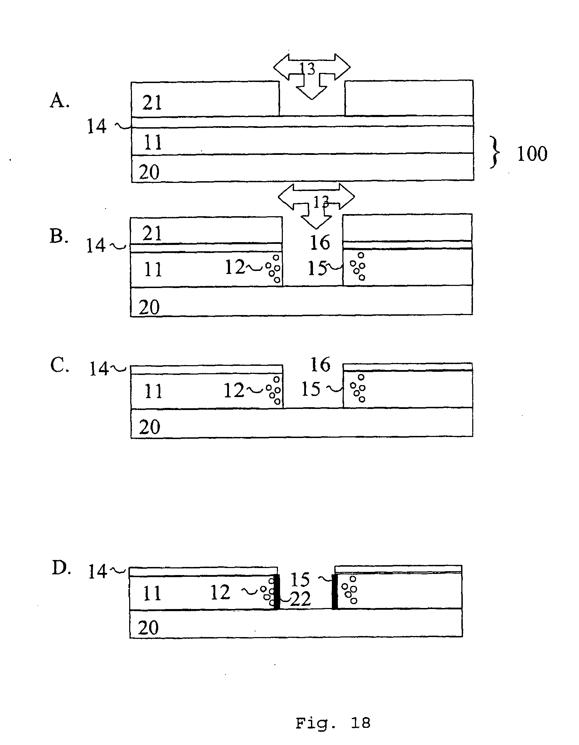

Figs. 18 a-d illustrate the sequence of creating an opening in a dielectric layer. This dielectric layer is part of a damascene dielectric stack. For the purpose of teaching the invention only the semiconductor substrate 100 is shown. This semiconductor substrate can be any substrate used in semiconductor industry such as silicon wafers and can further comprise active devices such as transistors or passive devices such as capacitors and resistors.

The substrate can further comprise patterned layers of dielectrics and conductive materials to form an interconnect structure. On top of this substrate only a single low-k dielectric layer 11 is shown, but the invention is not limited thereto. On top of this low-k dielectric a top hard mask layer 14 can be formed as is normal practice in damascene back-end-of-line (BEOL) technology.

As shown in Figs. 18a-b the patterning of the dielectric stack, in this example the low-k dielectric 11 and the hard mask 14, comprises the steps of depositing and patterning in a lithographic process step a resist layer 21 (Fig. 18a). The pattern established in the resist layer 21 is then transferred to the underlying layers, which in this example are the hard mask 14 and the low-k dielectric 11.

The resist pattern is transferred by creating a dry etch plasma 13 that interacts with the exposed parts of the underlying layers. In Fig. 18b the etch plasma 13 creates an opening 16 in the dielectric stack. In the side walls 15 of the opening 16 the etch plasma can create pores 12 or change the porosity of the low-k dielectric layer 11. As explained previously this change in porosity will result in a locally decreased dielectric constant. Once the opening is created the protective resist layer 21 is removed. The protective resist layer 21 can also be removed during the process of creating the opening 16.

Fig. 18c shows the device after patterning the opening 16. In damascene processing typically a diffusion barrier layer, e.g. nitride or SiC, will be deposited followed by the formation of a stack of conductive layers, e.g. Cu seed layer used for plating Cu on the wafer. These process steps are known to a person skilled in the art and are therefore not shown.

Although the dielectric constant can be locally decreased during the step of creating the opening subsequent processing might a negative impact on these local k value. Although the surface of the dielectric layer 11 can be protected by a hard mask 14, the openings 16 formed in the hard mask and in the dielectric layer to receive the barrier and conductive layers make the low-k dielectric susceptible to further processing.

These openings 16 give access to the low-k dielectric and the surface of the low-k dielectric remains exposed and hence unprotected. In the paper "Critical issues in the integration of Copper and low-k dielectrics, by R. A. Donaton et al., proceedings of the IEEE 1999 International Interconnect Technology Conference" results are shown of interline capacitance measurements with two different cleaning solutions.

As can be seen, the negative impact of the cleaning solution that is used can be high. It is to be expected that the problem of cleaning of porous materials will even be much more difficult, but also for the nonporous low-k materials, the danger of low-k material modification in the cleaning step is clear and present. A reason for this degradation might be that the thus created pores 12 are filled with residues or materials during further processing.

The present invention therefore discloses a method for preserving this local k-value by sealing the exposed surfaces of the porous dielectric layers. Fig. 18d shows the sealing of pores 12 created from the side walls 15 of the low-k dielectric 11 onwards. The sealing results from the formation of a layer 22 at least on these side walls 15. This protective or sealing layer 22 can be formed after the step of patterning the opening 16 and stripping the resist layer 21. This protective layer 22 can be formed during the step of creating the opening 16. This protective layer 22 can be formed during the step of removing the resist layer 21. The protective layer can be formed using a plasma comprising oxygen and nitrogen.

In a preferred embodiment, the dry etch plasma conditions could be for instance :
etch tool : high density plasma reactor (TCP 9100)
gaseous mixture for the plasma etch : O₂ and N₂
etch conditions in chamber: 7 mTorr
Rf top power : 1700 watt
Rf bottom power : 300 watt
hard mask layer is a PECVD oxide layer with a thickness of 250 nm
thickness of the resist layer (Sumitomo I-line) : 1.2 µm
thickness of SILK layer: 1.1 µm
underlying layer: TiN layer
set-point temperature : 20 °C.

## Claims

1. A process for forming a semiconductor substrate comprising the steps of:
- depositing and patterning a resist layer (21) in a lithographic process on a substrate (100) having at least a dielectric layer (11) and a hard mask (14);
- transferring the established pattern in the resist layer (21) to the underlying layers (14,11) of said substrate (100) by using a dry etch plasma (13) thereby creating an opening (16) in the substrate (100), said dry etch plasma interacting with the exposed parts of the underlying layers (14,11) of said substrate (100), thereby creating pores (12) or changing the porosity in the dielectric layer (11);
- stripping said resist layer (21);.
- performing a sealing step on the side walls (15) of said opening (16) created in said substrate (100) by using a O₂/N₂ dry etch plasma (13); said sealing stop preserving the local k-value reached on the porous dielectric layer (11);
wherein said dielectric layer is a low-k material layer which is a silicon-oxygen-carbon containing material and the hard mask layer (14) comprises silicon carbide.

2. A process according to claim 1 wherein the dry etch plasma used to transfer the established pattern is an Ar/CF₄/CHF₃/O₂ plasma.

3. A process as in any of the previous claims, **characterised in that** said sealing step is performed after the step of patterning the opening (16) and/or stripping the resist layer (21).

4. A process as in any of the previous claims, **characterised in that** said sealing step is performed during the step of stripping the resist layer (21).

## Patentansprüche

1. Verfahren zum Bilden eines Halbleitersubstrats, das die folgenden Schritte umfasst:
- Ablagern und Strukturieren einer Resistschicht (21) in einem lithographischen Verfahren auf einem Substrat (100) mit zumindest einer dielektrischen Schicht (11) und einer Hartmaske (14);
- Übertragen der gebildeten Struktur in der Resistschicht (21) auf die zugrunde liegenden Schichten (14, 11) des Substrats (100) unter Verwendung eines Trockenätzplasmas (13) wodurch eine Öffnung (16) im Substrat (100) gebildet wird, wobei das Trockenätzplasma mit den exponierten Teilen der zugrunde liegenden Schichten (14, 11) des Substrats (100) interagiert, wodurch Poren (12) gebildet werden oder die Porosität in der dielektrischen Schicht (12) geändert wird;
- Abstreifen der Resistschicht (21);
- Durchführen eines Versiegelungsschritts an den Seitenwänden (15) der Öffnung (16) die im Substrat (100) gebildet ist unter Verwendung eines O₂/N₂-Trockenätzplasmas (13); wobei der Versiegelungsschritt den lokalen k-Wert aufrecht erhält der auf der porösen dielektrischen Schicht (11) erreicht ist;
wobei die dielektrische Schicht eine Low-k-Materialschicht ist, die ein Silicium-Sauerstoff-Kohlenstoffhaltiges Material ist und wobei die Hartmaskenschicht (14) Siliciumcarbid umfasst.

2. Verfahren nach Anspruch 1 wobei das zum Übertragen der gebildeten Struktur verwendete Trockenätzplasma ein Ar/CF₄/CHF₃/O₂-Plasma ist.

3. Verfahren nach einem der vorstehenden Ansprüche, **dadurch gekennzeichnet dass** der Versiegelungsschritt nach dem Schritt des Strukturierens der Öffnung (16) und/oder des Abstreifens der Resistschicht (21) durchgeführt wird.

4. Verfahren nach einem der vorstehenden Ansprüche, **dadurch gekennzeichnet dass** der Versiegelungsschritt während des Schritts des Abstreifens der Resistschicht (21) durchgeführt wird.

## Revendications

1. Procédé pour former un substrat semi-conducteur comprenant les étapes de :
- dépôt et modelage d'une couche de réserve (21) dans un procédé lithographique sur un substrat (100) ayant au moins une couche diélectrique (11) et un masque dur (14) ;
- transfert du motif établi dans la couche de réserve (21) aux couches sous-jacentes (14, 11) dudit substrat (100) en utilisant un plasma de gravure sèche (13) de manière à créer une ouverture (16) dans le substrat (100), ledit plasma de gravure sèche interagissant avec les parties exposées des couches sous-jacentes (14,11) dudit substrat (100) de manière à créer des pores (12) ou modifier la porosité dans la couche diélectrique (11) ;
- décapage de ladite couche de réserve (21) ;
- conduite d'une étape de scellement sur les parois latérales (15) de ladite ouverture (16) créée dans ledit substrat (100) en utilisant un plasma de gravure sèche O₂/N₂ (13) ; ledit arrêt de scellement préservant la valeur k locale atteinte sur la couche diélectrique poreuse (11) ;
dans lequel ladite couche diélectrique est un matériau à k faible qui est un matériau contenant du silicium-oxygène-carbone et la couche de masque dur (14) comprend du carbure de silicium.

2. Procédé selon la revendication 1, dans lequel le plasma de gravure sèche utilisé pour transférer le motif établi est un plasma Ar/CF₄/CHF₃/O₂.

3. Procédé selon l'une quelconque des revendications précédentes, **caractérisé en ce que** ladite étape de scellement est effectuée après l'étape de modelage de l'ouverture (16) et/ou décapage de la couche de réserve (21).

4. Procédé selon l'une quelconque des revendications précédentes, **caractérisé en ce que** ladite étape de scellement est effectuée pendant l'étape de décapage de la couche de réserve (21).
